# EUROPEAN PATENT APPLICATION

(11) **EP 4 287 242 A1**
(43) Date of publication of application: **06.12.2023**
(21) Application number: 22177166.0
(22) Date of filing: 03.06.2022
(51) Int. Cl.: H01L 21/48, H01L 23/495

(54) **CONNECTING ELEMENT, WELDED CONNECTION, METHOD FOR PRODUCING A METAL PART COMPRISING THE CONNECTING ELEMENT, CONNECTION KIT, AND METHOD FOR CONNECTING A METAL PART TO A LEAD**

(71) Applicant: TE Connectivity Germany GmbH, 64625 Bensheim (DE)
(72) Inventor: GLASER, Karlheinz, 64625 Bensheim (DE); SCHULZ, Eric, 67346 Speyer (DE)
(74) Representative: Grünecker Patent- und Rechtsanwälte PartG mbB

(57) **Abstract**

Connecting element (100) formed on a metal part (200) for resistance welding a lead (300) to the metal part. The connecting element comprises a pin (110) protruding from a connecting surface (144) of the connecting element, the pin having a height (h) in the direction of protrusion (160), and the pin for welding the lead to the metal part when heated. Further, the connecting element comprises a wall (140) surrounding the pin, the wall for contacting at the connecting surface (144) of the lead when the metal part has been welded to the lead. Further, the connecting element comprises a groove (130) disposed between a foundation (120) of the pin and the wall, the groove formed by a recess in the connecting surface so that the groove has a depth (d) in a direction opposite to the direction of protrusion (160), and the groove for receiving material molten during the resistance welding.

## Description

The invention relates to a connecting element, a welded connection, a method for producing a metal part comprising the connecting element, a connection kit, and a method for connecting a metal part to a lead.

Parameters, e.g. temperature, current, or voltage, of metal parts, e.g. a busbar for contacting batteries or a shunt, need to be monitored. For monitoring parameters, sensors need to be electrically connected to the metal parts. For example, a lead of a lead frame is used to conduct electrical signals from the metal part to a connector interface, which can be connected to a semiconducting element such as a die, which is a small block of semiconducting material on which a given functional circuit, e.g. a temperature sensor, is fabricated.

Various connection mechanisms are available for electrically connecting a lead to a metal part. For example, the metal part may be connected by parts such as bolts or rivets, adhesives, welding, or soldering. However, the above discussed existing technologies are not all offering an appropriate solution for a strong connection of the lead to the metal part. In particular, the solution needs to be economic, robust, provide an electrical connection, provides a sufficient strong connection with a peel force of whereby the mechanical strength is determined by the minimum material strength of the components. Peel strength or peel force is generally used to measure the bond strength of the connection. The peel force respects the load required to separate the connected materials where the angle of separation is more than 90°.

As used herein, welding is a fabrication process that joins materials, usually metals, by using high heat to melt the parts together and allowing them to cool, causing fusion. Welding is distinct from lower temperature techniques such as brazing and soldering, which do not melt the base metal (parent metal). Welding provides particularly strong connections.

Many different energy sources can be used for welding, including a gas flame (chemical), an electric arc (electrical), a laser, an electron beam, friction, or ultrasound, or an electrical resistance to a current flow through a metal part. Welding is a potential hazardous undertaking and precautions are required to avoid burns, electric shock, vision damage, inhalation of poisonous gases and fumes, and exposure to intense ultraviolet radiation. In view of the lead frame being equipped with electrical components, welding methods as for example ultrasound welding can damage the electrical components. Further, laser or electron beam welding process can be unsuitable in view of cost considerations.

In particular, resistance welding can be used to weld a lead to a metal part because both parts are electrical conductors and used for conducting electrical signals. For example, Fig. 11 shows an arrangement for resistance welding. In particular, a first metal part 2000 comprises a pin 1010. This part is to be welded to a second metal part 3000.

Resistance welding involves the generation of heat by passing current through a high resistance section. For example, in Fig. 11, the high resistance section is the pin, which is arranged between the two or more metal surfaces, i.e. a surfaces 1012 of the pin 1010 and a surface 3002 of the second metal part 3000.

In view of the resistance in the pin 1010 being increased because the cross section of the pin being smaller than the cross section of the first metal part and the second metal part, small pools of molten metal are formed at the weld area as high current (e.g. arc welding 10 A to 1000 A, direct current welding with inverter 400 A to 50000 A) is passed through the metal. In general, resistance welding methods are efficient, but their applications are somewhat limited. Thus, resistance welding enables a process for connecting a lead to a metal part without effecting the electrical components by vibrations on the lead frame and at the same time the connection is sufficiently strong and economic to realize.

The problem with resistance welding in view of welding a lead of a lead frame to a metal part is that resistance welding causes pollution. In particular, in case of welding a lead of a lead frame, which can comprise or consist of a copper alloy such as CuSn4, is that the lead has a lower melting temperature in comparison to the metal part such as a bus bar or shunt, which for example comprises or consists of copper. A further object is that the lead usually is dimensioned, smaller than a metal part such as a busbar or a shunt, and thus, the lead has a lower thermal conductivity in view of the dimensions in comparison to the metal part. In other words, the metal part such as a bus bar is more massive than the lead of a lead frame and thus is behaving like a heat sink. Thus, heat is confined in the lead while heat is efficiently transported away from the pin by the metal part.

In view of the above, during a resistance welding process, the material of the lead can melt and the material of the pin of the metal part does not necessarily melt. The melted material of the lead, e.g. a copper alloy like CuSn4, can splash outside of the welding zone. This is a problem in view of cleanliness requirements. In particular, loose metal particles are problematic.

At least one of objects discussed above is solved by the independent claims. Advantageous embodiments are solved by the dependent claims.

In particular, the present disclosure proposes to form, e.g. to coin, a groove around a pin, i.e. a welding pin. This groove enables capturing the bleeding or splashing melted material caused in view of joining the metal part to the lead by a resistance welding process. Thus, a lead can be connected to a metal part and loose particles may be avoided.

As used herein, a lead frame is for distributing bidirectional digital or analog signals or electrical power to e.g. a sensing element or power consumers or interfaces like connector elements. The mechanical and electrical interconnection section points or leads are elements in a structured shape out of metal, the so called lead frame.. Mechanical connections fix all these parts into a rigid structure, which makes the whole lead frame easy to handle automatically.

As used herein, a busbar (also mentioned as bus bar) is a metal part, e.g. a metallic strip or bar, typically housed inside switchgear, panel boards, and busway enclosures for local high current power distribution. They are also used to connect high voltage equipment at electrical switchyards, and low voltage equipment in battery banks. These features allow sufficient cooling of the conductors, and the ability to tap in at various points without creating a new joint. Thus, the lead can be connected to a metal part such as a bus bar.

As used herein, a shunt is a metal part that creates a low-resistance path, preferably largely temperature-independent path for electric current, to allow a portion of the current in the circuit to pass through the shunt in parallel to an additional current flow path.. The lead can be connected to a metal part such as a shunt.

In more detail, herein is disclosed a connecting element formed on a metal part. As used herein and described above, the metal part is in particular a conductor such as a bus bar or a shunt for electrically connecting parts such as batteries.

Forming a connecting element means that the connecting element is for example coined, stamped, or fabricated so that the connecting element is inseparable connected with the metal part. Inseparable in particular means that the connecting element cannot be separated from the metal part without destroying the connecting element, the metal part, or the connection. Advantageously, the metal part and the connecting part are fabricated as one piece, e.g. by a stamping process.

The connecting element enables resistance welding of a lead to the metal part. As used herein and described above, the lead is in particular a conductor for conducting electrical signals. In more detail, the lead, which is for example arranged on a lead frame, is for conducting electrical signals from the metal part to a connector interface. For example, the connector interface may enable realizing the function of sensing temperature, current, or voltage.

As described above, resistance welding is melting metal at a weld area by using high current. Thus, resistance welding enables a strong permanent connection between the metal part and the lead, wherein the weld comprises after the welding process material of at least one of the connecting element and the lead.

Further, the connecting element comprises a pin protruding from a connecting surface of the connecting element. The pin, which is also referred to as welding pin, has a height in the direction of protrusion. As used herein, the pin is a device used for fastening objects together, i.e. the pin is participating in welding the parts. In particular, the pin is a shaft, i.e. a columnar structure, of a material that can be used for welding, i.e. can melt when high current is passed through.

In more detail, the pin has an extension in a plane normal to the direction of protrusion thereby defining a pin cross section, which is also referred to as wire cross section or line cross section. In other words, the pin is cylindrically shaped with a top base being a contacting surface for contacting the pin to the lead, a bottom base for contacting the pin via a foundation of the pin to the metal part, and a circumferential side face being in contact with ambient, i.e. being not in electrical contact with the lead or the metal part. For example, the plane normal to the direction of protrusion is parallel to at least one of the connecting surface, the contacting surface, and the bottom base.

The pin height and the pin cross section defines the resistance for passing current from the metal part to the lead. In particular, as the pin has the columnar structure, the cross section of the pin is less than the cross section of the metal part and the cross section of the lead. Thus, the resistance increases in the pin due to the smaller cross section. Thus, when a current is passed through the metal part to the lead via the pin, the pin has the highest resistance. Thus, the pin is heated in view of the increased resistance thereby enabling resistance welding.

The heat generated in the pin causes that at least one of the pins, the lead, and the metal part to melt. In particular, the heat may be confined in the pin thereby melting the pin. Additionally, the heat is conducted to the lead. In view of a possible lower melting temperature of the lead and a possible lower thermal capacity of the lead compared to the metal part, the lead may melt. The metal part may not melt.

As used herein and described above, by the welding process the parts are joint permanently together. In particular, in a first phase transition, at least one of the parts, here the pin, the metal part, and the lead, are melted. By cooling the molten material, a second phase transition occurs, namely solidification of the molten material the molten material thereby forming the weld. Thus, the pin enables for welding the lead to the metal part when heated. In particular, the pin and the lead are melted and a fusion of material of the lead and the pin forms the weld.

Further, the connecting element comprises a wall surrounding the pin. A wall is a solid structure that provides a barrier or enclosure. In more detail, the wall is for contacting at the connecting surface the lead when the metal part has been welded to the lead.

In other words, the connecting surface of the wall is facing a connecting surface of the lead. Before the welding, the connecting surface of the wall and the connecting surface of the lead are spaced apart in the direction of protrusion. The distance between the connecting surface of the wall and the connecting surface of the lead being the height of the pin. During the welding, the connecting surface of the wall and the connecting surface of the lead come in contact, or nearly in contact. For example, during the welding process, an external pressure is applied to the lead in the direction of protrusion. In particular, during applying pressure the pin and/or the lead are in liquid phase and thus the connecting surface of the wall can pressed to come in contact with the connecting surface of the lead. Thus, after the resistance welding has terminated, the wall and the lead are in contact or nearly in contact.

Further, the connecting element comprises a groove disposed between a foundation of the pin and the wall. As used herein, a groove is a slot or trench formed into a member, i.e. the metal part. As used herein, a foundation is the element of a structure that connects the pin to the connecting element. In particular, the groove runs relative, e.g. parallel, to a structure formed in the member, i.e. the foundation of pin. For example, in case the foundation of the pin having a circular cross section, the groove is annularly shaped.

Further, the groove is formed by a recess in the connecting surface so that the groove has a depth in a direction opposite to the direction of protrusion. In other words, the groove is a recess formed between an inner wall surface of the wall and a circumferential side surface of the foundation of the pin, the inner wall surface facing the circumferential side surface of the foundation of the pin.

For example, the recess is generated by the wall protruding from a top surface of the metal part, wherein the connecting element is arranged on the top surface. Additionally or alternatively, the inner wall surface may be formed by milling a recess in the metal part.

The groove enables for receiving molten material during the resistance welding process. In particular, because of the arrangement of the groove between the wall and the foundation of the pin, the groove provides space for the molten material and the wall encloses the molten material when the welding process has terminated. Thus, splashed molted material is confined or enclosed by the wall.

According to one aspect, the height of the pin is less equal 1 mm, preferably the height of the pin of the connecting element is less equal 0.75 mm, even more preferably the height is less equal 0.6 mm. This height being measured from the connecting surface to the top base surface, i.e. the contacting surface, of the pin. In other words, the height defines how much material has to be melted during the welding process. The shorter the pin, the less material has to be melted.

According to an alternative or additional aspect, the height of the pin of the connecting element is greater equal 0.1 mm, preferably the height is greater equal 0.25 mm, even more preferably the height is greater equal 0.4 mm. A longer pin increases the tolerance by placing the parts relative to one another. In particular, a longer pin enables that the parts may not become in contact before the welding, for example by a misalignment allowing the wall come in contact with the lead by tilting the parts.

According to an alternative or additional aspect, a diameter of the pin of the connecting element is less equal 1.5 mm, preferably the diameter is less equal 1 mm, even more preferably the diameter is less equal 0.75 mm. The diameter of the pin being measure in a plane normal to the direction of protrusion. The smaller the diameter, the higher the resistance and thus the higher the heat generated in the pin.

According to an alternative or additional aspect, the diameter of the pin of the connecting element is greater equal 0.1 mm, preferably the diameter is greater equal 0.2 mm, even more preferably the diameter is greater equal 0.3 mm. The larger the diameter, the more robust is the connection element and in particular the pin.

According to an alternative or additional aspect, the depth of the groove of the connecting element is less equal 1 mm, preferably the depth is less equal 0.75 mm, even more preferably the depth is less equal 0.4 mm. This depth being measured from the connecting surface to the base surface of the foundation of the pin. In other words, the depth is one of the measures defining the aspect ratio, i.e. the ratio of the depth of a structure, i.e. the groove, to its (smallest) lateral extent. In general, the larger the aspect ratio and the smaller the absolute size of the structure, the more difficult it is to manufacture. Thus, a smaller depth, e.g. only 0.4 mm, is easier to manufacture.

According to an alternative or additional aspect, the depth of the connecting element is greater equal 0.1 mm, preferably the depth is greater equal 0.25 mm, even more preferably the depth is greater equal 0.3 mm. The deeper the depth, the larger the aspect ratio and thus the smaller the extension of the connection element in the lateral dimension to enclose the same volume.

According to an alternative or additional aspect, the groove encloses a volume greater or equal than a volume of the pin. The volume being enclosed from the surfaces of groove, i.e. the inner surface of the wall, the opposing circumferential surface of the foundation of the pin, the connecting surface of the connecting element, and a bottom surface of the groove. The bottom surface of the groove opposes the connecting surface of the connecting element. The volume of the pin being for example measured by the diameter of the pin times the depth. The larger the volume the more material can be enclosed in the groove. Thus, it is made sure that all molten material is enclosed.

According to an alternative or additional aspect, the groove encloses a volume less than two times the volume of the pin. The smaller the volume the denser the material is enclosed in the groove. Thus, the probability of loose particles is reduced. Loose particles may escape through the walls if the walls are not completely enclosing the groove after the welding.

According to an alternative or additional aspect, the pin comprises or consist of Cu. Thus, the pin can be formed from the material of the metal part, which usually comprises or consists of Cu.

A further aspect of the description relates to a metal part, the metal part comprising the connecting element according to any of the above described aspects of connecting elements. The metal part has a bottom surface, the bottom surface opposing the connecting surface of the connecting element.

According to an aspect, the metal part has a thickness of more or equal than 1 mm between the bottom surface and the connecting surface. Preferably, the metal part has a thickness of more or equal than 1.5 mm. Such a thickness allows to conduct high currents through the metal part.

According to an additional or alternative aspect, the metal part has a thickness of less or equal than 5 mm between the bottom surface and the connecting surface. Preferably, the metal part has a thickness of less or equal than 4 mm. Such a thickness allows to fabricate the metal part economic. In particular, in case of a metal part comprising or consisting of Copper or the like, the metal part becomes expensive. Further, in weight critical applications, e.g. a metal parts for aviation, the metal part must be fabricated as light weight as possible.

According to an additional or alternative aspect, the metal part comprises a notch that is formed in the bottom surface of the metal part. In particular, by stamping a notch in the bottom surface, on the opposing connecting surface can be formed the connecting element. Thus, the metal part can be produced cost efficient.

A further aspect of the description relates to a connection kit comprising the metal part according to any of the above described aspects. Further the connection kit comprises a lead. The lead for joining to the connecting surface of the metal part by resistance welding. For a detailed description of the lead is referred to the above description.

According to an aspect, the metal part is a busbar or shunt and the lead is comprised on a lead frame for transmitting signals to a connector interface, the die for enabling the function of measuring a parameter of the busbar or the shunt. With regard to the description of busbar, shunt, lead, lead frame, and connector interface is referred to the above. In particular, this arrangement enables for realizing a welded connection for measuring a temperature of the metal part.

According to an additional or alternative aspect, the melting temperature of the metal part is higher than the melting temperature of the lead. Thus, even in this case of having, for example, a busbar consisting or comprising Cu, which has a melting temperature of 1085 °C, and a lead frame consisting or comprising a copper alloy, e.g. CuSn4 having a melting temperature of 960-1070 °C, resistance welding can be used and cleanliness requirement can be met in view of the groove.

According to an additional or alternative aspect, the thermal capacity of the metal part is higher than the thermal capacity of the lead. In particular, the lead of the lead frame has a thickness of greater equal 0.4 mm and/or less equal 0.8 mm. Thus, even in this case of having for example a busbar made a massive metal part, e.g. having a thickness greater equal 1 mm, and a lead frame made having thin lead, e.g. having a thickness of less equal 0.8 mm, resistance welding can be used and cleanliness can be achieved in view of the groove.

According to an additional or alternative aspect, the metal part comprises Cu and/or the lead comprises a copper-alloy, like CuSn4, or an iron-nickel alloy. Thus, even in this case of having for example a busbar made of Cu, which has a melting temperature of 1085 °C, and a lead frame made of a copper alloy, e.g. CuSn4 having a melting temperature of 960-1070 °C, resistance welding can be used and cleanliness can be achieved in view of the groove.

An aspect of the present description relates to a welded connection connecting a lead to a metal part via a connecting element. For the description of the lead, the metal part and the connection element is referred to the above description.

Further, the connecting element comprises a weld. The weld comprises solidified material. A pin of the weld protrudes from a connecting surface of the connecting element in a direction of protrusion. For the description of the pin of the weld is referred to the description of the pin of the connection element. In particular, the pin of the weld is based on the pin of the connecting element, wherein the pin of the connecting element has been partly transformed during the welding process.

In particular, the weld comprises at least material of a pin of the connecting element, the pin being from the material of the connecting element. Further, the weld may comprise material of the lead. In view of the welding process, the pin may be partially or completely be melted. Additionally, the weld may comprise material of the lead because the lead may melt during the welding process. According to one example, the weld may only comprise material of the lead.

Further, the welded connection comprises a wall surrounding the weld, the wall contacting at the connecting surface the lead. Further, the welded connection comprises a groove disposed between a foundation of the weld and the wall, the groove formed by a recess in the connecting surface so that the groove has a depth in a direction opposite to the direction of protrusion and the groove at least partly be filled with material molten during the resistance welding.

In particular, the welded connection may be realized using a connecting element described above. Further, the welded connection may be realized using a metal part described above. Further, the welded connection may be realized using a connection kit described above.

Further, the present application relates to a method for producing a metal part for resistance welding a lead to the metal part, the method comprising the steps of stamping the metal part to form the connecting element of any of the above discussed connecting elements. In particular, in view of the stamping process a notch is formed in a bottom surface of the metal part, the bottom surface opposing the connecting surface.

In particular, the method relates to manufacturing a connecting element described above. Further, the method relates to manufacturing a metal part described above. Further, the method relates for manufacturing a connection kit described above.

Further, the present application relates to a method for connecting a metal part to a lead, the method comprising the steps of
contacting a pin of a connecting element of the metal part to the lead, the pin protruding from a connecting surface of the connecting element;
joining the metal part to the lead by resistance welding for forming a weld;
catching molten material of the weld by a groove disposed between a wall surrounding the pin and a foundation of the pin; and
enclosing the molten material of the weld by the wall, the wall contacting at the connecting surface the lead when the pin has been molten.

In particular, the method relates to connecting a connecting element described above. Further, the method relates to connecting a metal part described above. Further, the method relates for connecting a connection kit described above.

According to an aspect, the method step of joining the metal part to the lead comprises the steps of
passing current for a predetermined length of time through the pin so that material melts for forming the weld, and
pressing the lead to the metal part so that the wall contacts the lead thereby enclosing the molten material in the groove.

Applying current, i.e. passing the current, and applying force, i.e. pressing the lead to the metal part, must be in parallel until the enclosing of the molten material in the groove is realized. In other words, the steps of passing current and pressing are performed simultaneously. In particular, a current of 1000-100,000 A is passed through the pin. In particular, a current of 2000 to 3000 A is passed through the pin. Further, a current is passed for a predetermined time of less than 5 ms, preferably of less than or equal to 2ms, through the pin. Even more advantageously, a current of less than or equal to 3000 A is passed for less than or equal to 2.5 ms through the pin.

According to an additional or alternative aspect, the method comprises the step of, before joining, conducting power through the connecting element for removing an oxide layer from the pin and/or the lead. This enables for cleaning the contact surfaces from oxide layers.

In particular, a power of 100-10,000 W is passed through the pin. In particular, a power of 500 to 2000 W is passed through the pin. Further, a power is passed for a predetermined time of less than 5 ms, preferably of less than or equal to 2ms, through the pin. Even more advantageously, a power of less than or equal to 2000 W is passed for less than or equal to 2.5ms through the pin.

The invention will now be described in greater detail and in an exemplary manner using advantageous embodiments and with reference to the drawings. The described embodiments are only possible configurations in which, however, the individual features as described above can be provided independently of one another or can be omitted.

The accompanying drawings are incorporated into the specification and form a part of the specification to illustrate several embodiments of the present invention. These drawings, together with the description serve to explain the principles of the invention. The drawings are merely for the purpose of illustrating the preferred and alternative examples of how the invention can be made and used, and are not to be construed as limiting the invention to only the illustrated and described embodiments. Furthermore, several aspects of the embodiments may form-individually or in different combinations-solutions according to the present invention. The following described embodiments thus can be considered either alone or in an arbitrary combination thereof. The described embodiments are merely possible configurations and it must be borne in mind that the individual features as described above can be provided independently of one another or can be omitted altogether while implementing this invention. Further features and advantages will become apparent from the following more particular description of the various embodiments of the invention, as illustrated in the accompanying drawings, in which like references refer to like elements, and wherein:
- **FIG. 1**: is a schematic of a connection element according to one aspect;
- **FIG. 2**: is a schematic of a connection kit according to one aspect before welding;
- **FIG. 3**: is a schematic of the connection kit of Fig. 2 after welding;
- **FIG. 4**: is a schematic of a metal part according to one aspect before forming a connecting element;
- **FIG. 5**: is a schematic of the metal part according Fig. 4 after forming a connecting element;
- **FIG. 6**: is a schematic of the metal part according Fig. 4 after forming a connecting element;
- **FIG. 7**: is a schematic of a method for connecting a metal part to a lead;

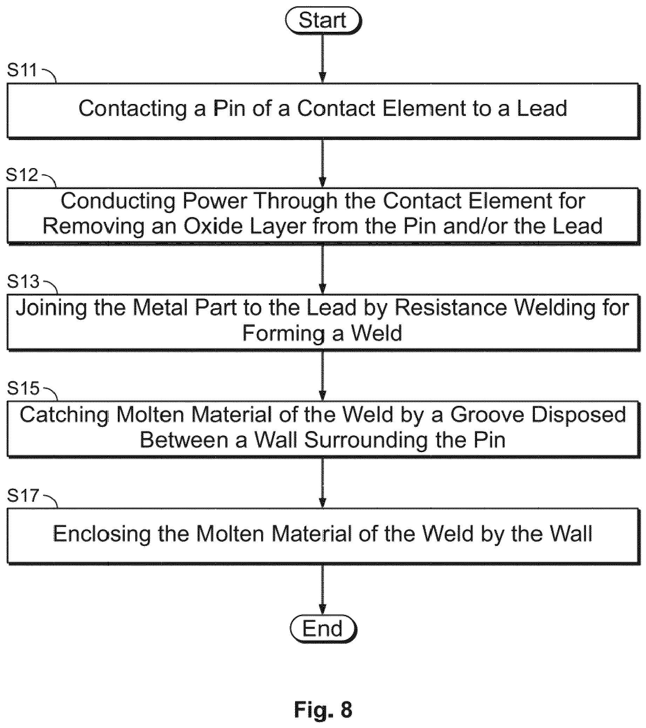

- **FIG. 8**: is an alternative schematic view of the process of Fig. 7;
- **FIG. 9**: is a schematic of a method for manufacturing a metal part; and
- **FIG. 10**: is a schematic of a connection kit for resistance welding.

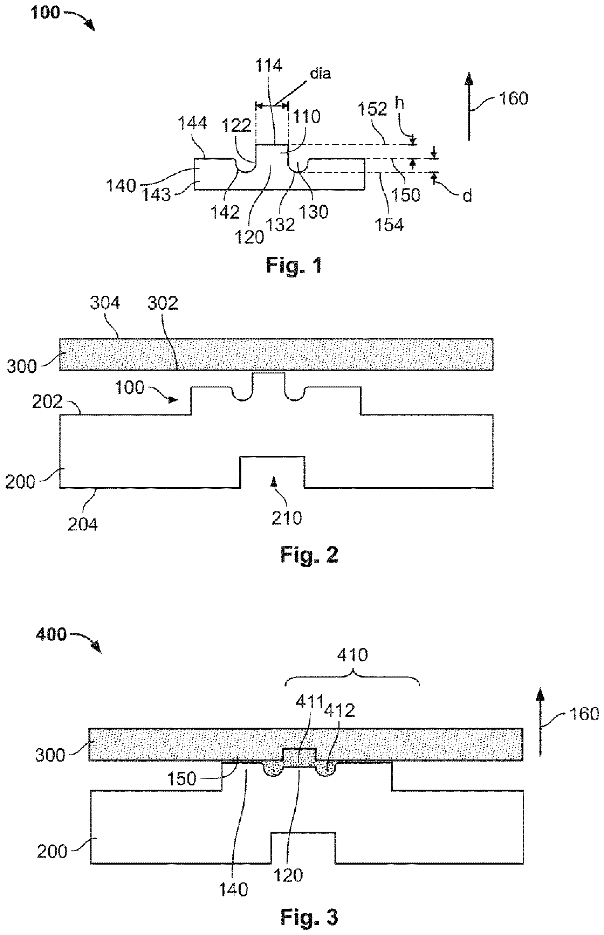

The present invention will now be explained in more detail with reference to the Figures. Referring to Fig. 1, a schematic of a connection element 100 according to one aspect is described. The connecting element 100 comprises a pin 110, a foundation 120 of the pin 110, a groove 130, and a wall 140.

In more detail, the pin 110 is protruding from a connecting surface 144 of the connecting element 100. The connecting surface 144 is indicated by dashed line 150. In particular, as will be described below, the connecting surface 144 comes in contact with a lead after the welding step.

The pin 110 has a height h in the direction of protrusion 160. In particular, the direction of protrusion is substantially perpendicular to the connecting surface 150.

Further, the pin 110 has a contacting surface 114. The contacting surface 114 for electrically contacting with the lead so that connecting element 110 can be joint to the lead by resistance welding. The contacting surface 114 is indicated by dashed line 152. The height h being measured between the contacting surface 114 and the connecting surface 144.

The pin 110 has lateral extension perpendicular to the direction of protrusion 160. The pin has a cross section indicated by reference expression dia. For example, the pin has a columnar structure. For example, the pin 110 has the shape of a cylinder.

The pin 110 being adapted for welding the lead to the metal part when heated. In particular, the pin 110 has a higher resistance than the metal part and the lead. Thus, when a high current is passed through the pint, the pin is heated, and thus, welding is enabled. As discussed above, the higher resistance is caused, for example, by the lateral dimension dia of the pin. Additionally or alternatively, the higher resistance may be caused by the choice of material of the pin.

Further, the connecting element 110 comprises a foundation 120 of the pin 110. In particular, the pin 110 is connected via the foundation 120 to the metal part. The foundation 120 has a circumferential surface 122 that is facing the groove 130. The foundation 120 enables passing current from the metal part to the pin.

According to the example shown in Fig. 1, the foundation 120 and the pin 110 have the substantially the same lateral dimension dia. Alternatively, the foundation may have a larger lateral dimension than the pin, for example, the foundation and the pin may form a cone with a tip for contacting the lead at the contacting surface 152.

Further, the connection element 100 comprises a wall 140. The wall 140 surrounding the pin 110. The wall has a surface forming the connecting surface 150. The wall contacts at section 144 of the contacting surface 150 the lead when the metal part has been welded to the lead.

In particular, the wall 140 has an inner wall surface 142 facing the groove 130. In particular, the inner surface is opposing the circumferential surface 122 of the foundation120. Further, the wall 140 may have an outer wall surface 143, the outer wall surface opposing the inner wall surface. Further, the wall 140 has a bottom surface opposing the connecting surface 144 for connecting the wall to the metal part.

Further, the connection element 100 comprises the groove 130. The groove is disposed between the foundation 120 of the pin 110 and the wall 130. The groove 130 is formed by a recess in the connecting surface 150 so that the groove has a depth d in a direction opposite to the direction of protrusion 160.

In particular, the groove 130 has a groove surface 132, which is indicated by dashed line 154. The depth d being measured between the connecting surface 144 and the groove surface 132. As shown in Fig. 1, the groove surface 132 is for example curved. According to a not shown example, the groove surface 132 may be flat and for example parallel to the connecting surface 144.

An aspect of the present description, which is shown in Fig. 2, relates to a metal part 200 comprising a connecting element 100. The connecting element 100 has been described with reference to above Fig. 1 and it is referred to the above for the description of the connecting element 100.

In particular, the metal part 200 comprises a top surface 202. The connecting element 100 is protruding from the top surface 202. Further, the metal part 200 comprises a bottom surface 204. The bottom surface 204 is opposing the top surface 202.

According to an aspect, which enables a simple fabrication, a notch 210 is formed in a bottom surface 204. Thus, by stamping the notch 210, the connecting element 100 is protruding from the top surface 202.

An aspect of the present description, which is shown in Fig. 2, relates to a connection kit comprising the metal part 200 and a lead 300. In particular, Fig. 2 shows the connection kit before the lead 300 is welded to the metal part 300 via the connection element 100.

The lead comprises a connecting surface 302 and an opposing attachment surface 304. For example, the lead 300 is attached to a lead frame at the attachment surface 304.

The welded connection 400 after welding the lead 300 to the metal part 200 is shown in Fig. 3. The welded connection 400 comprising a weld 410. The weld 410 comprising solidified material.

As shown in Fig. 3, a pin 411 of the weld 410 protrudes from a connecting surface 150 of the connecting element in a direction of protrusion 160. For the description of the pin 411 of the weld is referred to above description of Fig. 1 and 2 of the pin of the connecting element. For illustration purposes, the pin 411 of the weld is illustrated as having the same shape as the pin 110. The pin 411 of the weld may have a different shape than the pin 110 of the connection element. However, the dimensions and the shape of the pin 411 of the weld may be similar to the dimensions and the shape of the pin 110.

In particular, the weld 400 is a fusion of molten material. The molten material may comprise material of the pin 110. Further, the weld 410 may comprise material of the lead, the lead have been described above.

Further, the welded connection comprises a wall 140 surrounding the weld 410, the wall 140 contacting at the connecting surface 150 the lead. For the description of the wall is referred to above description of Figs. 1 and 2.

Further, the welded connection comprises a groove disposed between a foundation 120 of the weld and the wall. The groove is formed by a recess in the connecting surface 150 so that the groove has a depth in a direction opposite to the direction of protrusion 160. Further, the groove is at least partly be filled with material 412 of the weld, the material 412 have been molten during the resistance welding. For the description of the groove is referred to above description of Figs. 1 and 2.

In particular, the height h of the pin 110 in Figs. 1 and 2 or the pin 411 of the weld 410 in Fig. 3 may be less equal 1 mm, preferably the height is less equal 0.75 mm, even more preferably the height is less equal 0.6 mm. Further, the height of the pin 110 in Figs. 1 and 2 or the pin 411 of the weld 410 in Fig. 3 may be greater equal 0.1 mm, preferably the height is greater equal 0.25 mm, even more preferably the height is greater equal 0.4 mm.

Further, a diameter dia of the pin 110 in Figs. 1 and 2, or the pin 411 of the weld 410 in Fig. 3 may be less equal 1.5 mm, preferably the diameter is less equal 1 mm, even more preferably the diameter is less equal 0.75 mm. Further, a diameter of the pin 110 in Figs. 1 and 2, or the pin 411 of the weld 410 in Fig. 3 may be greater equal 0.1 mm, preferably the diameter is greater equal 0.2 mm, even more preferably the diameter is greater equal 0.3 mm.

Further, a depth of the groove 130 in Figs. 1 to 3 may be less equal 1 mm, preferably the depth is less equal 0.75 mm, even more preferably the depth is less equal 0.4 mm. Further, a depth of the groove 130 in Figs 1 to 3 may be greater equal 0.1 mm, preferably the depth is greater equal 0.25 mm, even more preferably the depth is greater equal 0.3 mm.

Further, the groove 130 in Figs. 1 to 3 may enclose a volume greater than or equal to a volume of the pin. Additionally or alternatively, the groove 130 in Figs 1 to 3 may enclose a volume less than two times the volume of the pin.

In particular, Fig. 3 shows that volume is completely filled by the melted portion. According to a not shown example, the volume may be filed by 20%.

Notably, Fig. 3 shows that the lead 300 and the metal part 200 are spaced apart and the melted portion enters in a gap between the lead 300 and the metal part 200. However, the molten material is not squeezed out. According to a not shown example, the lead 300 and the metal part 200 may be in contact so that melted portion is completely enclosed.

Further, the metal part in Figs 1 to 3 may have a thickness of more or equal than 1 mm between the bottom surface and the connecting surface. Additionally or alternatively, the metal part in Figs 1 to 3 may have a thickness of less or equal than 5 mm between the bottom surface and the connecting surface.

Further, the metal part in Figs. 2 to 3 may be a busbar or shunt. Further, the lead in Figs. 2 to 3 may be comprised on a lead frame for connecting a die, the die for enabling the function of measuring a parameter of the busbar or the shunt.

Further, the melting temperature of the metal part in Figs. 2 to 3 may be higher than the melting temperature of the lead in Figs. 2 to 3.

Further, the thermal capacity of the metal part in Figs. 2 to 3 may higher than the thermal capacity of the lead in Figs. 2 to 3.

Further, metal part of Figs. 2 to 3 may comprise or consist of Cu. Further, the lead of Figs. 2 to 3 may comprise or consist a copper-alloy, like CuSn4, or an iron-nickel alloy.

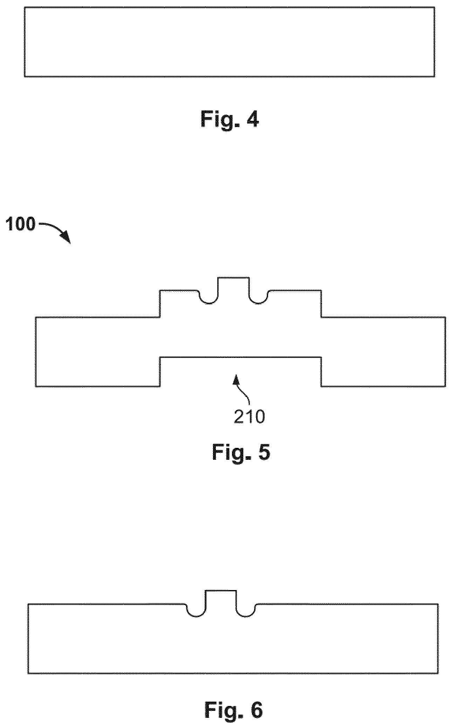

A fabrication method for producing a metal part for resistance welding a lead is described with reference to Figs. 4 and 5. In particular, as shown in Fig. 4 a metal part having an elongated shape is provided. Further, a connecting element 100 is formed in the metal part by stamping the metal part of Fig. 4. Thus, the structure of Fig. 5 is formed. For the description of the connecting element 100 is referred to above Figs. 1 and 2. For the description of the metal part is referred to the above description of Fig. 2. Further, the metal part comprises a notch 210 that is formed in a bottom surface of the metal part, the bottom surface opposing the connecting surface.

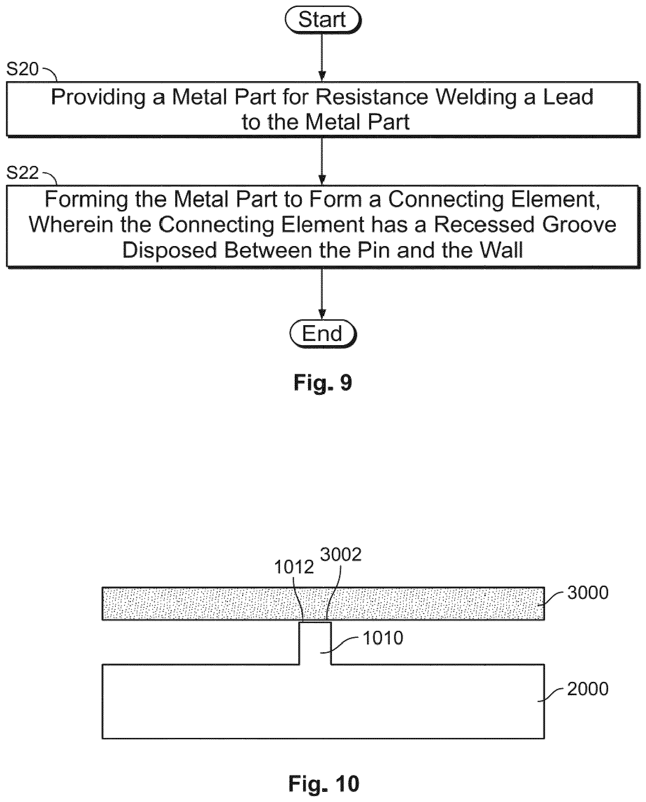

A corresponding flow diagram of the fabrication process is shown in Fig. 10. In particular, the process comprises the step S20 of providing a metal part for resistance welding a lead to the metal part. Further, the method comprises the step S22 of stamping the metal part to form a connecting element, wherein the connecting element has a recessed groove disposed between a pin and a wall.

An alternative fabrication method is described with reference to Figs. 4 and 6. In particular, as shown in Fig. 4 a metal part having an elongated shape is provided. Further, a connecting element 100 is formed in the metal part by recessing the metal part of Fig. 4. Thus, the structure of Fig. 6 is formed. For the description of the connecting element 100 is referred to above Figs. 1 and 2.The above description of the metal part is applicable. Notably, the wall does not comprise the outer wall surface.

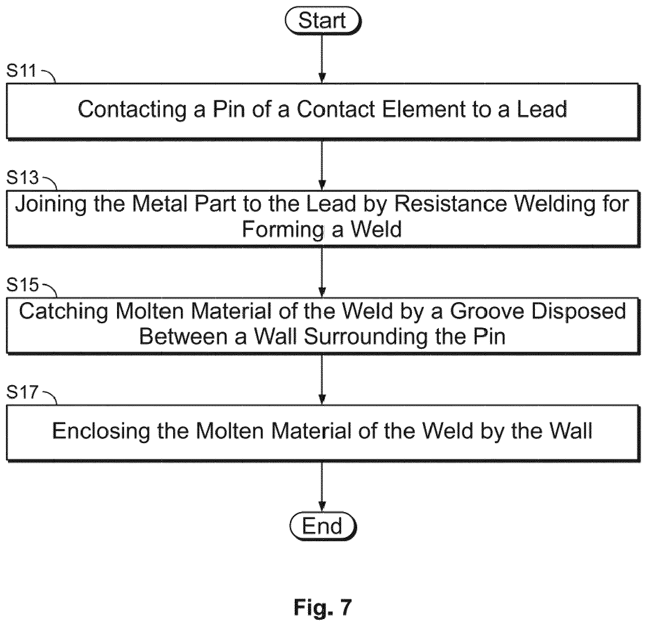

Further, with reference to Fig. 7 is described a method for connecting a metal part, e.g. the metal part described in Figs. 2, 3, 5 or, to a lead, e.g. the lead described in Fig. 2 to 3.

The method comprises the step S11 of contacting a pin of a connecting element of the metal part to the lead, the pin protruding from a connecting surface of the contacting element. This step enables that parts, i.e. the pin and the lead, are in electrical connection for enabling resistance welding.

Further, the method comprises the step S13 of joining the metal part to the lead by resistance welding for forming a weld. In particular, a high current is passed through the connected parts for a predetermined time.

Further, the method comprises the step S15 of catching molten material of the weld by a groove disposed between a wall surrounding the pin. Thus, the generation of loose particles can be prevented.

Further, the method comprises the step S17 of enclosing the molten material of the weld by the wall, the wall contacting at the connecting surface the lead when the lead is welded to the metal part. Thus, a particular strong connection between lead and metal part is enabled and the loose particles are enclosed.

Advantageously, the step of joining S13 is carried out as further detailed. In particular, joining the comprises the step of passing current for a predetermined length of time through the pin so that material melts for forming the weld. Thus, it is precisely controlled how much energy is introduced to melt the parts and thereby forming the welded connection. Further, the step of joining comprises the step of pressing the lead to the metal part so that the wall contacts the lead thereby enclosing the molten material in the groove. The steps of the steps of passing current and pressing are performed simultaneously.

According to a further aspect, the method for connecting a metal part to a lead comprises the steps discussed in Fig. 9. The method of Fig. 9 comprises in addition to the method of Fig. 7 the step S12 of conducting power through the contact element for removing an oxide layer from the pin and/or the lead. For the further steps is referred to Fig. 7.

In particular, the step S12 is performed after the step S11 and before the step S13. This step enables cleaning the connecting surface because oxygen is removed. This is a particular economic method for removing the oxygen layer because the set up for resistance welding can be used for removing the oxide layer.

**REFERENCE NUMERALS**

| **Reference Numeral** | **Description** |
|---|---|
| 100 | connecting element |
| 110 | pin |
| 114, 152 | contactinq surface |
| 120 | foundation |
| 122 | circumferential surface |
| 130 | groove |
| 132, 154 | groove surface |
| 140 | wall |
| 142 | Inner wall surface |
| 143 | Outer wall surface |
| 144, 150 | Connecting surface |
| 200, 2000 | Metal part |
| 202 | Top surface |
| 204 | Bottom surface |
| 210 | Notch |
| 300, 3000 | Lead |
| 302 | Connecting surface |
| 304 | Attachment surface |
| 400 | Welded connection |
| 410 | weld |
| 411 | Pin of weld |
| 412 | Material of weld |
| 1010 | Pin |
| 1012 | Surface of pin |
| 2000 | First metal part |
| 3000 | Second metal part |
| 3002 | Surface of second metal part |

## Claims

1. Connecting element (100) formed on a metal part (200) for resistance welding a lead (300) to the metal part, the connecting element comprises:
a pin (110) protruding from a connecting surface (144) of the connecting element, the pin having a height (h) in the direction of protrusion (160), and the pin for welding the lead to the metal part when heated,
a wall (140) surrounding the pin, the wall for contacting at the connecting surface (144) of the lead when the metal part has been welded to the lead, and
a groove (130) disposed between a foundation (120) of the pin and the wall, the groove formed by a recess in the connecting surface so that the groove has a depth (d) in a direction opposite to the direction of protrusion (160), and the groove for receiving material molten during the resistance welding.

2. Connecting element according to claim 1, wherein the height is less equal 1 mm, preferably the height is less equal 0.75 mm, even more preferably the height is less equal 0.6 mm, and/or wherein the height is greater equal 0.1 mm, preferably the height is greater equal 0.25 mm, even more preferably the height is greater equal 0.4 mm.

3. Connecting element according to any of claims 1 to 2, wherein a diameter of the pin is less equal 1.5 mm, preferably the diameter is less equal 1 mm, even more preferably the diameter is less equal 0.75 mm, and/or wherein a diameter of the pin is greater equal 0.1 mm, preferably the diameter is greater equal 0.2 mm, even more preferably the diameter is greater equal 0.3 mm.

4. Connecting element according to any of claims 1 to 3, wherein the depth is less equal 1 mm, preferably the depth is less equal 0.75 mm, even more preferably the depth is less equal 0.4 mm, and/or wherein the depth is greater equal 0.1 mm, preferably the depth is greater equal 0.25 mm, even more preferably the depth is greater equal 0.3 mm.

5. Connecting element according to any of claims 1 to 4, wherein the groove encloses a volume greater or equal than a volume of the pin and/or wherein the groove encloses a volume less than two times the volume of the pin.

6. Metal part (200) comprising the connecting element according to any of claims 1 to 5, wherein the metal part has a bottom surface (204), the bottom surface opposing the connecting surface (144), optionally wherein the metal part has a thickness of more or equal than 1 mm between the bottom surface and the connecting surface and/or wherein the metal part has a thickness of less or equal than 5 mm between the bottom surface and the connecting surface.

7. Metal part according to claim 7, wherein a notch (210) is formed in the bottom surface.

8. Connection kit comprising the metal part according to any of claims 6 or 7 and a lead, the lead for joining to the connecting surface of the metal part by resistance welding, optionally wherein the metal part is a busbar or shunt and the lead is comprised on a lead frame for connecting a transmitting signals to a connector interface, the connector interface for enabling the function of measuring a parameter of the busbar or the shunt.

9. Connection kit according to claim 8, wherein the melting temperature of the metal part is higher than the melting temperature of the lead.

10. Connection kit according to any of claims 8 or 9, wherein the thermal capacity of the metal part is higher than the thermal capacity of the lead.

11. Connection kit according to any of claims 8 to 10 wherein the metal part comprises Cu and/or the lead comprises a copper-alloy, like CuSn4, or an iron-nickel alloy.

12. Welded connection (400) connecting a lead to a metal part via a connecting element, the connecting element comprises:
a weld (410), the weld comprising hardened material, a pin (411) of weld protruding from a connecting surface (144) of the connecting element in a direction of protrusion (160),
a wall (140) surrounding the weld, the wall contacting at the connecting surface the lead, and
a groove (130) disposed between a foundation (120) of the weld and the wall, the groove formed by a recess in the connecting surface so that the groove has a depth (d) in a direction opposite to the direction of protrusion (160), and the groove at least partly be filled with material (412) of the weld, the material have been molten during the resistance welding.

13. Method for producing a metal part for resistance welding a lead, the method comprising the steps of
Stamping the metal part to form the connecting element of any of claims 1 to 6 so that a notch is formed in a bottom surface of the metal part, the bottom surface opposing the connecting surface.

14. Method for connecting a metal part to a lead, the method comprising the steps of
contacting a pin of a connecting element of the metal part to the lead, the pin protruding from a connecting surface of the contacting element;
joining the metal part to the lead by resistance welding for forming a weld;
catching molten material of the weld by a groove disposed between a wall surrounding the pin;
enclosing the molten material of the weld by the wall, the wall contacting at the connecting surface the lead when the lead is welded to the metal part.

15. Method according to claim 14, wherein joining the metal part to the lead comprises
passing current for a predetermined length of time through the pin so that material melts for forming the weld, and
pressing the lead to the metal part so that the wall contacts the lead thereby enclosing the molten material in the groove,
wherein the method optionally comprises the step of, before joining, conducting power through the contact element for removing an oxide layer from the pin and/or the lead.
